# EUROPEAN PATENT APPLICATION

(11) **EP 2 144 289 A2**
(43) Date of publication of application: **13.01.2010**
(21) Application number: 08160109.8
(22) Date of filing: 10.07.2008
(51) Int. Cl.: H01L 27/15

(54) **Fabrication structure for light emitting diode component**

(30) Priority: 10.07.2008 US 73579
(71) Applicant: Intematix Technology Center Corp., Yangmei Township T'ao yuan 326 (TW)
(72) Inventor: Su, Hwa, Taipei City 106 (TW); Wang, Alexander Chan, Taipei City 106 (TW)
(74) Representative: Escher, Thomas

(57) **Abstract**

The fabrication structure for light emitting diode component is disclosed. The fabrication structure of the present invention includes a substrate, a plurality of cavities, a plurality of selection units, a first and a second directional predetermined cut. The plurality of cavities are arranged and disposed on the substrate to form an M rows × N columns matrix array. M and N are respectively a positive integer. Each selection unit corresponds to each cavity. The first directional predetermined cut is disposed between the rows, and the second directional predetermined cut is disposed between the columns. The first directional predetermined cut and the second directional predetermined cut are utilized to divide the substrate according to the plurality of selection units to obtain a X rows × Y columns area from the M rows × N columns matrix array. The fabrication structure of the present invention has high density and can be flexibly expanded upon demands.

## Description

### FIELD OF THE INVENTION

The present invention generally relates to a fabrication structure for light emitting diode component, and more particularly to two predetermined cuts that are utilized to flexibly divide the substrate upon demands, thereby achieving the goal of obtaining the required areas having high density from a matrix array of the substrate.

### BACKGROUND OF THE INVENTION

Light Emitting Diode (LED) is now in widespread use since the brightness of the LEDs is enhanced. The LEDs are applied to the lighting market gradually in addition to traffic signals, indicators, etc.

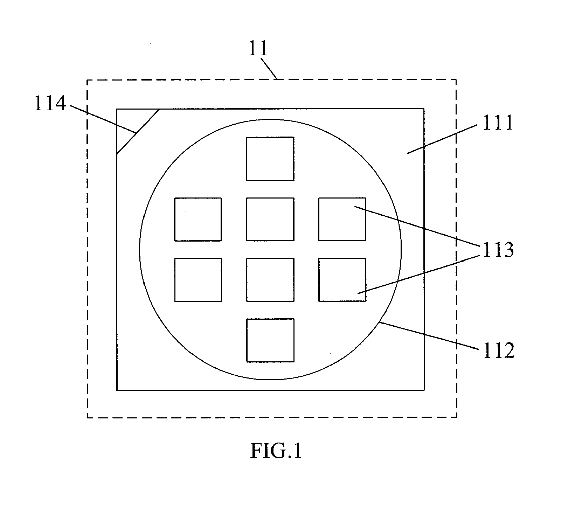

Referring to FIG. 1 for a schematic diagram illustrates a conventional single light emitting element applied to a fabrication structure. The single light emitting element 11 comprises a substrate 111, a hole 112, eight dies 113, and an electric label 114. The substrate 111 of the single light emitting element 11 is a ceramic substrate. Generally speaking, the element of the fabrication structure in the prior art disposes a bigger hole 112 on the substrate 111. The eight dies 113 then are arranged into the hole 112. The die 113 can be a LED. Finally, an electric label 114 is marked on the upper-left corner of the substrate 111 to mark the electrical interconnection of these dies 113 disposed on the substrate 111. In the fabrication structure, the ceramic substrate of the single light emitting element 11 has a bigger portion that results in wasting spaces since the dies 112 are not disposed on the portion.

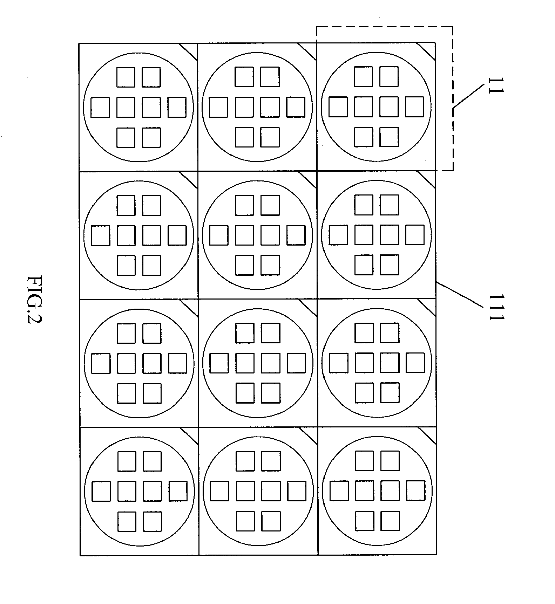

Referring to FIG. 2 for a schematic diagram illustrates a plurality of light emitting elements of a fabrication structure in the prior art. The fabrication structure is to make a plurality of single light emitting elements 11 as shown in FIG. 1 on a bigger substrate 111. The light emitting elements 11 obtained by the fabrication structure may waste the space since dies 112 are not mounted on a bigger portion of the ceramic substrate, and non-uniform luminescence may occur due to the non-uniform distribution of the dies 113.

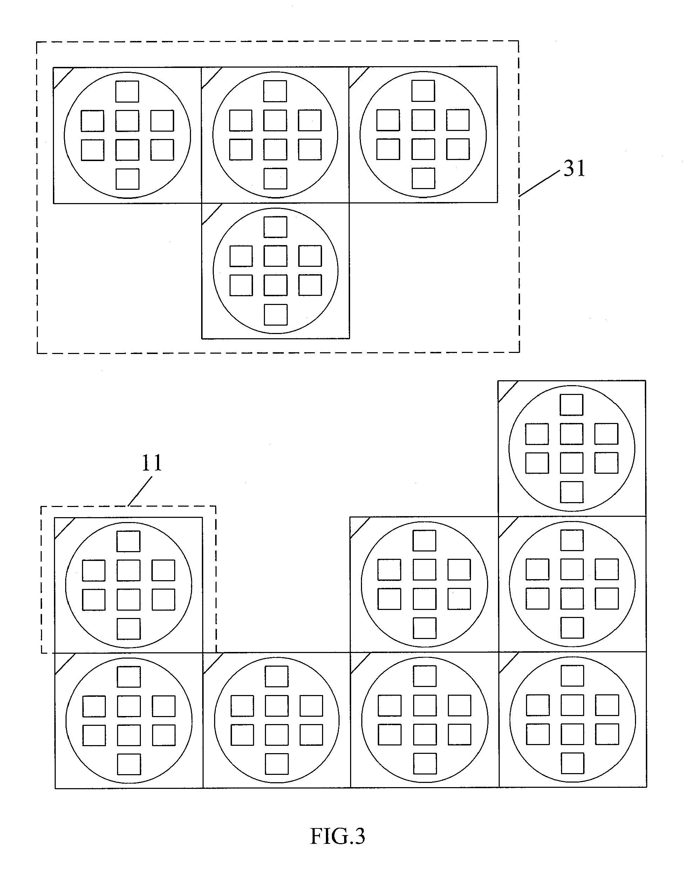

Referring to FIG. 3 for a schematic diagram of dividing a plurality of light emitting elements is illustrated. The division is executed based on the plurality of light emitting elements 11 as shown in FIG. 2, and divided based on the dies 113 formed by eight light emitting diodes so as to be shown in the division area 31. Users may not perform the division according to the required shapes, and must perform the division based on the unit composed of eight dies. The division of inflexibility does not only waste cost, but also has non-uniform luminescence.

To overcome the foregoing shortcoming, the inventor of the present invention based on years of experience in the related field to conduct extensive researches and experiments, and finally invented a fabrication structure for light emitting diode component as a method or a basis for resolving the foregoing drawback.

### SUMMARY OF THE INVENTION

Briefly, it is a first objective of the present invention to provide a fabrication structure for light emitting diode component. The fabrication structure has high density and can be flexibly expanded upon demands.

To achieve the foregoing objective, the fabrication structure of the present invention includes a substrate, a plurality of cavities, a plurality of selection units, a first and a second directional predetermined cut. The plurality of cavities are arranged and disposed on the substrate to form an M rows × N columns matrix array. M and N are respectively a positive integer. Each selection unit corresponds to each cavity. The first directional predetermined cut is disposed between the rows, and the second directional predetermined cut is disposed between the columns. The first directional predetermined cut and the second directional predetermined cut are utilized to divide the substrate according to the plurality of selection units to obtain a X rows × Y columns area from the M rows × N columns matrix array.

The cavity can be provided for accommodating a component made of a die or a light emitting diode chip. The substrate can be made of ceramic or glass having waterproof function. Alternatively, the substrate can be composed of silicon having well thermal conductivity. The first and second directional predetermined cut can be formed in V-shaped that is so called the V-cut. The cavity can be formed in a circle or a polygon. The cavities disposed on the substrate can be formed through the mold press. The M rows × N columns matrix array can be a chip array, and X and Y are smaller than M and N.

Since there is no need to perform the division based on the unit composed of eight dies in the prior art, users can obtain desired shapes upon demands, and the uniform-luminescence can be achieved. Further, since the fabrication structure is made, the manufacture cost can be reduced, and the yield rate is improved, and the development speed is increased, and the customized demand is therefore satisfied.

It is another objective of the present invention to provide a fabrication structure for a light emitting diode component. The structure includes a substrate having an array composed of cavities. Each cavity is configured to receive a light emitting diode chip, and the cavities are uniformly configured on the substrate so that the substrate is selectively dividable into light emitting diode components, and cut by using a first directional predetermined cut and a second directional predetermined cut.

To make it easier for our examiner to understand the object of the invention, its innovative features and performance, a detailed description and technical characteristics of the present invention are described together with the drawings as follows.

### BRIEF DESCRIPTION OF THE DRAWINGS

FIG. 1 is a schematic diagram of a conventional single light emitting element applied to a fabrication structure;
FIG. 2 is a schematic diagram of a plurality of light emitting elements of a fabrication structure in the prior art;
FIG. 3 is a schematic diagram of dividing a plurality of light emitting elements;
FIG. 4 is a schematic diagram of a fabrication structure for a light emitting diode component according to an embodiment of present invention
FIG. 5 is a cross-sectional drawing of a relationship between the directional predetermined cut and the cavities disposed on the substrate of the present invention;
FIG. 6 is a schematic diagram of square cavities of a fabrication structure for a light emitting diode component of the present invention;
FIG. 7 is a schematic diagram of a fabrication structure for a light emitting diode according to another embodiment of the present invention;
FIG. 8 is a schematic diagram of the substrate that is divided based on a single die as a selection unit according to FIG. 7;
FIG. 9 is a schematic diagram of sixteen light emitting diodes that are arranged in parallel connection according to an embodiment of the present invention;
FIG. 10 is a schematic diagram of sixteen light emitting diodes and an electrical label arranged on the fabrication structure of the present invention;
FIG. 11 is a schematic diagram of a schematic diagram of a fabrication structure for a light emitting diode component according to a further embodiment of the present invention; and
FIG. 12 is a flowchart of a flowchart illustrates a method of fabricating a light emitting diode component of the present invention.

### DETAILED DESCRIPTION OF THE PREFERRED EMBODIMENTS

Referring to the related figures for the fabrication structure for light emitting diode component according to a preferred embodiment of the present invention, wherein the same elements are described by the same reference numerals.

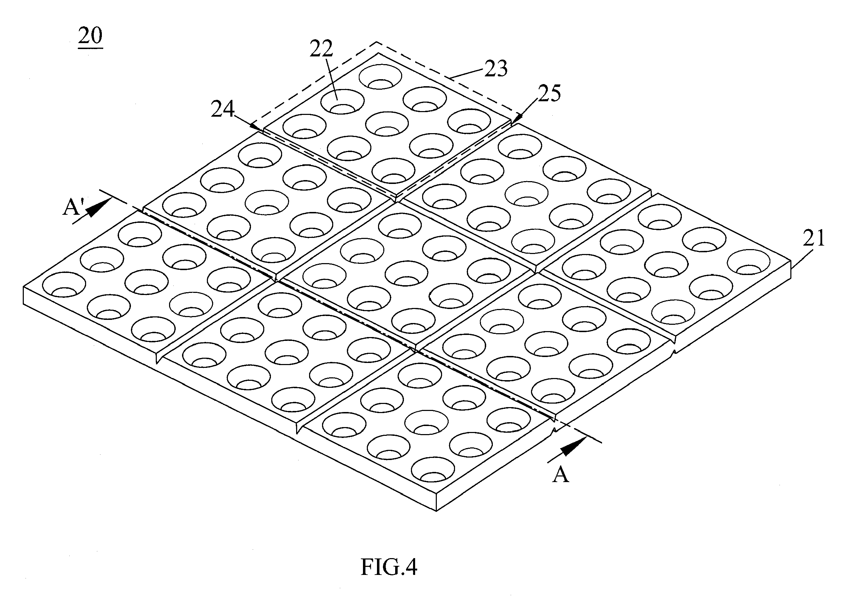

Referring to FIG 4 for a schematic diagram illustrates a fabrication structure for light emitting diode component according to an embodiment of present invention. The fabrication structure 20 includes a substrate 21, a plurality of cavities 22, a plurality of selection units 23 (as shown in dashed lines), a first directional predetermined cut 24 and a second directional predetermined cut 25. The plurality of cavities 22 are preferably arranged and disposed on the substrate 21 to form a 9 rows × 9 columns matrix array. It should be noted that the 10 rows × 10 columns matrix array is only an example, and the numbers of rows and columns of the matrix array can be expanded upon demands, such as a 12 rows × 15 columns matrix array or other M rows × N columns. Each selection unit 23 can correspond to each cavity 22. In another word, the minimum selection units 23 can also count up to one selection unit. The first directional predetermined cut 24 is preferably disposed between the rows, and the second directional predetermined cut 25 is preferably disposed between the columns. The first directional predetermined cut 24 and the second directional predetermined cut 25 are employed to divide the substrate 21 according to the plurality of selection units 23 to obtain a 3 rows × 3 columns area from the 9 rows × 9 columns matrix array. It should be noted that the disposition of the first and second directional predetermined cut 24, 25 can be flexibly disposed according to required shapes. In this embodiment, the first directional predetermined cut 24 is disposed between every 3 rows, and the second directional predetermined cut 25 is disposed between every 3 columns. Moreover, the 3 rows × 3 columns area is only an example, and the area can be obtained upon users' demands, such as a 2 rows × 2 columns area or other a X rows × Y columns area to achieve the flexibility.

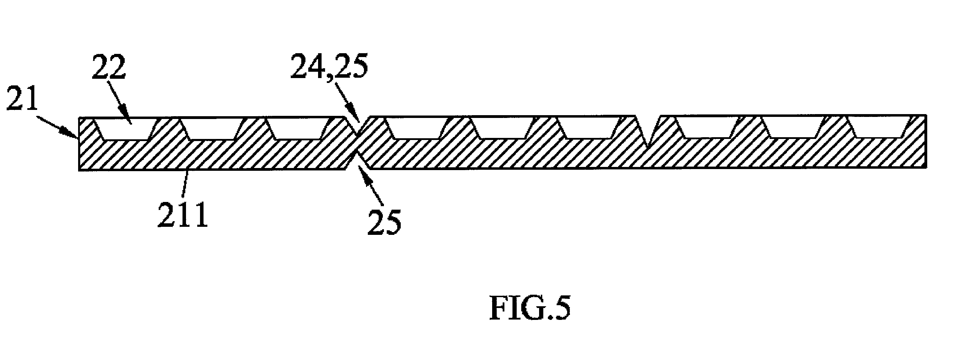

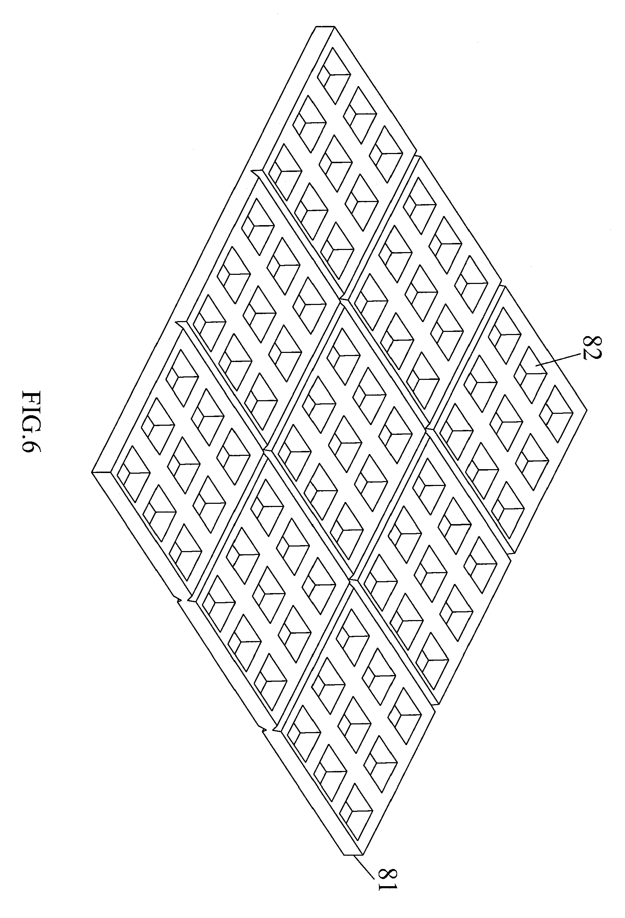

In this embodiment of the fabrication structure 20, the cavities 22 are provided for accommodating components made of a die or a light emitting diode chip (not shown in the figure). The substrate 21 is preferably made of ceramic or glass having waterproof function and heat dissipation ability. Alternatively, the substrate 21 is preferably composed of silicon having well thermal conductivity. The first directional predetermined cut 24 and the second directional predetermined cut 25 are preformed in V-shaped that is so called the V-cut. Namely, the first directional predetermined cut 24 and the second directional predetermined cut 25 are the horizontal and vertical directional V-cut respectively. FIG. 5 shows a cross-sectional view A-A' illustrating the relationship between the cavities and the V-cuts of the substrate of the fabrication structure according to FIG. 4. It should be noted that the vertical and horizontal directional V-cuts 24, 25 are not only disposed on the substrate 21 having the cavities 22, but are also disposed to a bottom 211 of the substrate 21 so as to easily split the desire shape. The formation of forming the cavities 22 disposed on the substrate 21 is made through the mold press. The M rows × N columns matrix array is a chip array panel. X and Y are always smaller than M and N, and M and N are respectively a positive integer. Further, the shape of the cavities is preferably formed in a circle as illustrated in the embodiment or a polygon such as a square as shown in FIG. 6. Since the square cavities 82 are uniformly disposed on the substrate 81 and light emitting diode chips (not shown in the figure) are also disposed therein, a planar light source is therefore obtained.

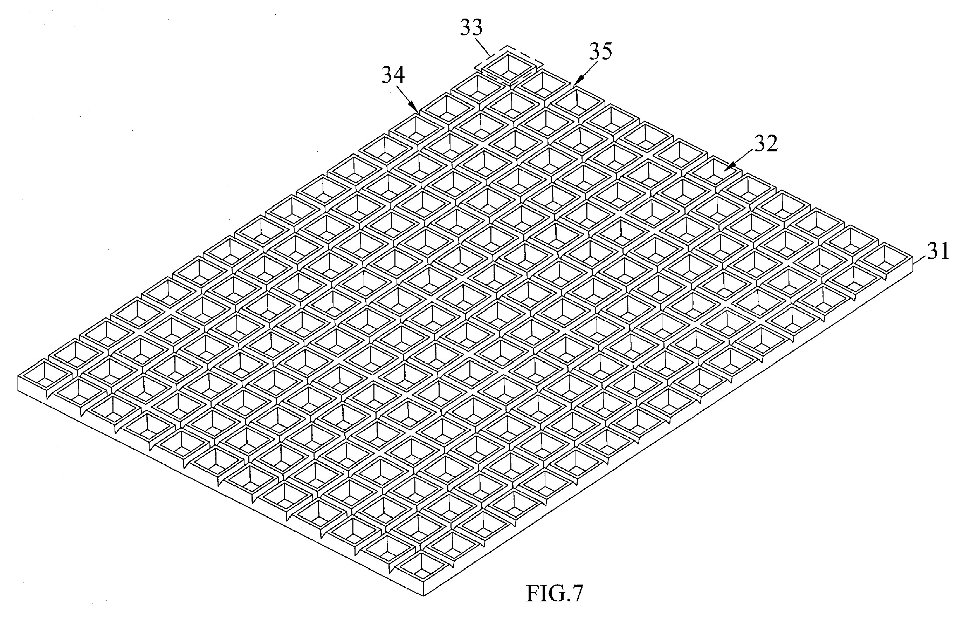

Referring to FIG 7, a schematic diagram illustrates a fabrication structure for light emitting diode according to another embodiment of the present invention. The fabrication structure 30 includes a substrate 31, a plurality of cavities 32 arranged and disposed on the substrate 31 to form a 12 rows × 16 columns matrix array, a plurality of selection units 33 (as referred dashed lines), a first directional V-cut 34 and a second directional V-cut 35. The first directional V-cut 34 is disposed between the rows, and the second directional V-cut 35 is disposed between the columns. Since each selection unit 33 corresponds to each cavity 32, the substrate 31 can be divided according to the selection unit 33 to obtain a one row × one column area from the 12 rows × 16 columns matrix array. The substrate 31 is preferably a ceramic substrate having waterproof function and heat dissipation ability. The cavity 32 is provided for accommodating a die (not shown in the figure), and can be a square cavity. Since the prior art shown in FIG. 2 only disposes 96 dies on the substrate based on eight dies, the fabrication structure 30 of the present invention can dispose 192 dies on the same substrate 31 to obtain light emitting elements with higher brightness and uniformity, thereby forming a surface light source.

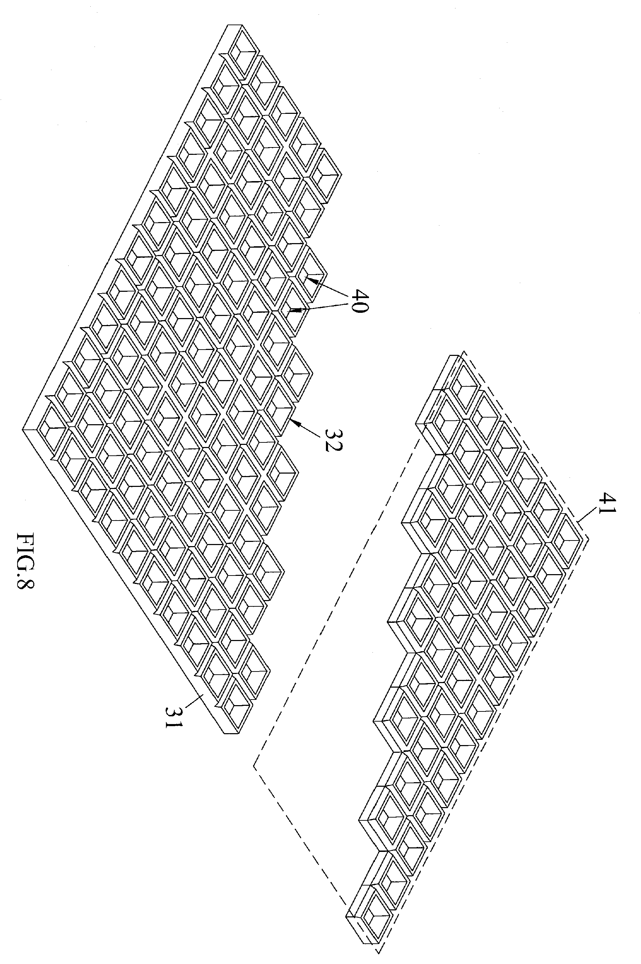

Referring to FIG. 8 for the schematic diagram illustrates the substrate that is divided based on a single die as a selection unit according to FIG. 7. The single die 40 is taken as the unit to perform the division according to required element shape 41. The high flexible division can reduce the manufacture cost to have the same effect of high density, high brightness and high uniformity.

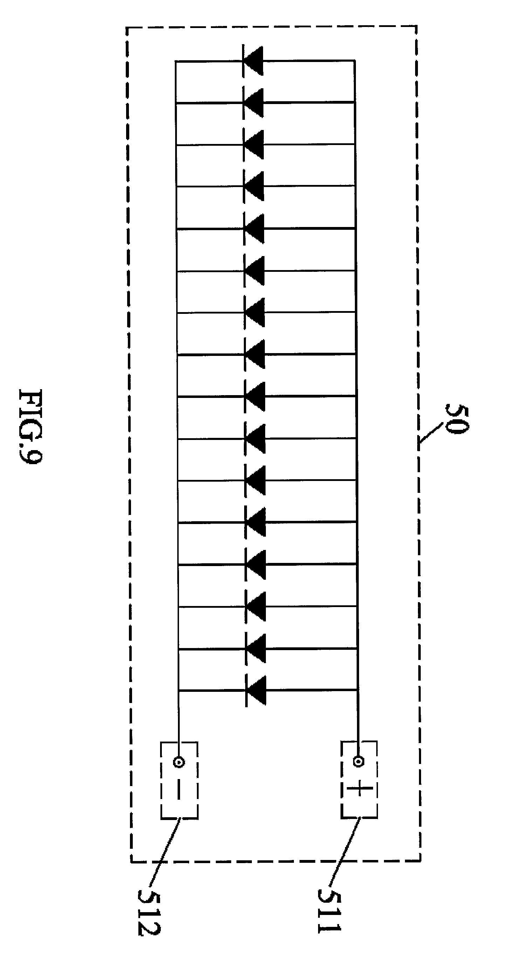

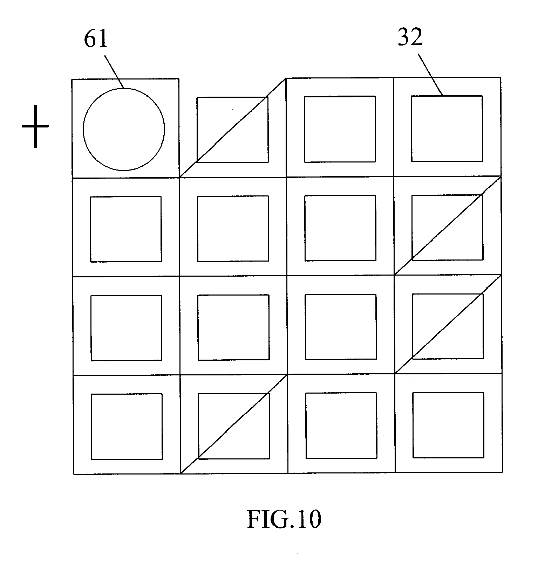

Referring to FIG. 9 for the schematic diagram illustrates sixteen light emitting diodes 50 that are arranged in parallel connection. The sixteen light emitting diodes arranged in parallel connection include an input end 511 and an output end 512, and can be made through the fabrication structure of the present invention. Referring to FIG. 10, a circular cavity 61 is taken as an electrical label for the input end 511 shown in FIG. 9 to differ from the square cavity 32. The convenience of determining electrical property is further provided while applying the element.

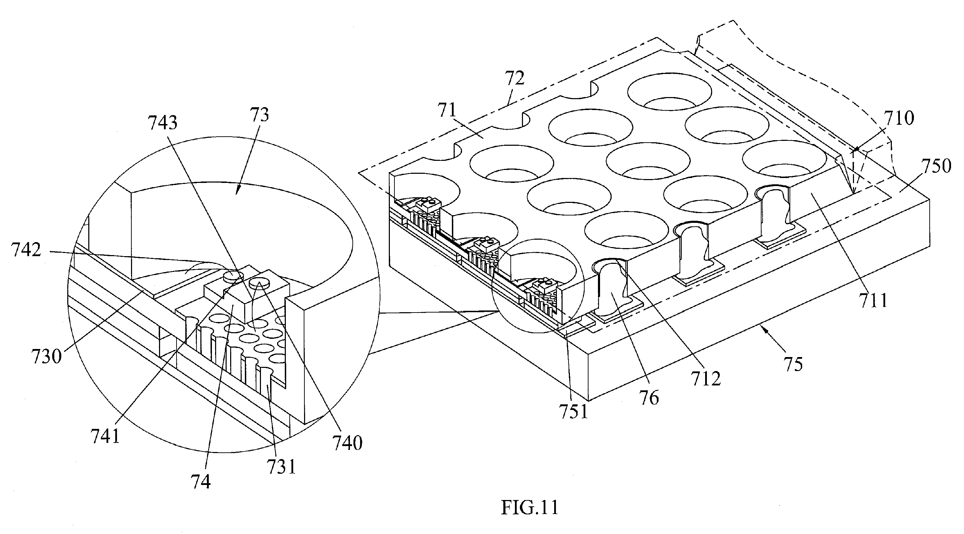

Referring to FIG. 11 for a schematic diagram illustrates a fabrication structure for a light emitting diode component according to a further embodiment of the present invention. The fabrication structure 70 includes a substrate 71 having an array 72 composed of cavities 73. Every cavity 73 is configured to accept a light emitting diode chip 74 and the size of the cavity 73 substantially corresponds to the light emitting diode chip 74, thereupon the substrate 71 is selectively dividable into light emitting diode components, and cut by using a vertical directional V-cut 710 and a horizontal directional V-cut 711.

The substrate 71 is generally disposed on coppers foil circuits 751 of a circuit board 75 such as a MCPCB (metal core printed circuit board), and made of silicon, ceramic or glass. A plurality of through holes 712 is arranged on the substrate 71 along the horizontal directional V-cut 711, and solders 76 are filled within the through holes 712 to connect the MCPCB circuits and the through holes 712. The through holes 712 arranged to the substrate 71 provide circuit wiring, enhance the welding area and increase thermal conductivity. The surface 750 of the MCPCB is coated with solder mask. The bottom of the cavity 73 has an inner circuit 730 for carrying the light emitting diode chip 74 and providing electrical serial connection for the LED chips 74, or binding dies. Two electrodes 740, 741 of the LED chip 74 made of a red LED chip, a green LED chip, a blue LED chip, a yellow LED chip, white LED chip or amber LED chip are connected by wires 742, 743 to the inner circuit 730 for electrical conduction. A plurality of thermal vias 731 is uniformly disposed on the inner circuit 730 and provided for dissipating heat generated by the LED chip 74. The co-fired electrode circuit 77 disposed to the rear of the substrate 71 can be connected by the thermal vias 731 to the inner circuit 730. Lastly, the solder 76 is utilized between the co-fired electrode circuit 77 disposed to the rear of the substrate 71 and the coppers foil circuits 751 of the MCPCB 75, thereby completing entire packaging.

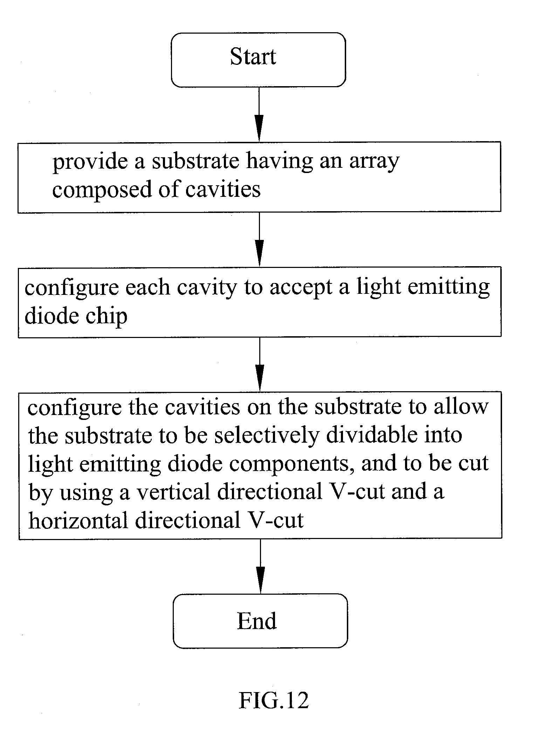

Referring to FIG. 12 for a flowchart illustrates a method of fabricating a light emitting diode component of the present invention. The method includes the following steps:
Step 80: provide a substrate having an array composed of cavities;
Step 81: configure each cavity to accept a light emitting diode chip; and
Step 82: configure the cavities on the substrate to allow the substrate to be selectively dividable into light emitting diode components, and to be cut by using a vertical directional V-cut and a horizontal directional V-cut.

The cavity can be provided for accommodating a component made of a die or a light emitting diode chip. The cavities are configured as a square array and wherein the substrate is dividable between cavities, and each cavity is substantially circle or a polygon. The substrate can be made of ceramic or glass having waterproof function. Alternatively, the substrate can be composed of silicon having well thermal conductivity.

While the invention has been described by way of example and in terms of a preferred embodiment, it is to be understood that the invention is not limited thereto. To the contrary, it is intended to cover various modifications and similar arrangements and procedures, and the scope of the appended claims therefore should be accorded the broadest interpretation so as to encompass all such modifications and similar arrangements and procedures.

## Claims

1. A fabrication structure for light emitting diode component, comprising:
a substrate;
a plurality of cavities arranged and disposed on the substrate to form an M rows × N columns matrix array, M and N being respectively a positive integer;
a plurality of selection units, each selection unit corresponding to the cavity;
a first directional predetermined cut disposed between the rows; and
a second directional predetermined cut disposed between the columns; wherein the first directional predetermined cut and the second directional predetermined cut are used to divide the substrate according to the plurality of selection units to obtain a X rows × Y columns area from the M rows × N columns matrix array.

2. The fabrication structure for a light emitting diode component as claimed in claim 1, wherein the substrate is made of ceramic, silicon or glass having waterproof function and heat dissipation ability.

3. The fabrication structure for a light emitting diode component as claimed in claim 1, wherein the substrate is composed of silicon having well thermal conductivity.

4. The fabrication structure for a light emitting diode component as claimed in claim 1, wherein the cavity is provided for accommodating a component.

5. The fabrication structure for a light emitting diode component as claimed in claim 4, wherein the component is a die or a light emitting diode chip.

6. The fabrication structure for a light emitting diode component as claimed in claim 1, wherein the first directional predetermined cut and the second directional predetermined cut are formed in V-shaped that is so called a V-cut.

7. The fabrication structure for a light emitting diode component as claimed in claim 1, wherein the cavity is formed in a circle or a polygon.

8. The fabrication structure for a light emitting diode component as claimed in claim 1, wherein the cavities disposed on the substrate are formed through the mold press.

9. The fabrication structure for a light emitting diode component as claimed in claim 1, wherein the M rows × N columns matrix array is a chip array panel.

10. The fabrication structure for a light emitting diode component as claimed in claim 1, wherein X and Y are smaller than M and N.

11. A fabrication structure for a light emitting diode component comprising:
a substrate having an array composed of cavities, each cavity being configured to receive a light emitting diode chip and wherein the cavities are configured on the substrate such that the substrate is selectively dividable into light emitting diode components, and cut by using a first directional predetermined cut and a second directional predetermined cut.

12. The structure as claimed in claim 11, wherein the cavities are configured such that the substrate is dividable into light emitting diode components comprising a single cavity.

13. The structure as claimed in claim 11, wherein the cavities are configured as a square array and wherein the substrate is dividable between cavities.

14. The structure as claimed in claim 11, wherein the substrate is a ceramic substrate, a glass substrate or a silicon substrate having waterproof function, heat dissipation ability or well thermal conductivity.

15. The structure as claimed in claim 11, wherein each cavity is substantially circle or a polygon.

16. The structure as claimed in claim 11, wherein the size of the light emitting diode chip substantially corresponds to the size of the cavity.

17. The structure as claimed in claim 11, wherein the first directional predetermined cut and the second directional predetermined cut are formed in V-shaped that is so called a V-cut.

18. The structure as claimed in claim 11, wherein the cavities configured on the substrate are formed through the mold press.
